# EUROPÄISCHE PATENTSCHRIFT

(11) **EP 1 133 674 B1**
(45) Veröffentlichungstag und Bekanntmachung des Hinweises auf die Patenterteilung: **06.05.2004**
(21) Anmeldenummer: 99964502.1
(22) Anmeldetag: 25.11.1999
(51) Int. Cl.: G01B 11/00

(54) **OPTOELEKTRONISCHE BAUEINHEIT**
OPTOELECTRONIC COMPONENT
BLOC DE COMPOSANTS OPTOELECTRONIQUES

(30) Priorität: 27.11.1998 DE 19854733
(43) Veröffentlichungstag der Anmeldung: 19.09.2001
(73) Patentinhaber: Dr. Johannes Heidenhain GmbH, 83292 Traunreut (DE)
(72) Erfinder: MICHEL, Dieter, D-83278 Traunstein (DE); HOLZAPFEL, Wolfgang, D-83119 Obing (DE); SPECKBACHER, Peter, D-84558 Kirchweidach (DE); BURGSCHAT, Reiner, D-07745 Jena (DE); BRODE, Wolfgang, D-07629 Hermsdorf (DE); SCHWARZROCK, Günter, D-99195 Erfurt-Schwerborn (DE); SCHMIDT, Andreas, D-99089 Erfurt (DE)
(86) Internationale Anmeldenummer: PCT/EP1999/009123
(87) Internationale Veröffentlichungsnummer: WO 2000/033022

(56) Entgegenhaltungen:
- WO-A-99/49514
- DE-A- 19 720 300
- US-A- 4 935 665
- US-A- 5 689 106
- US-A- 5 786 589
- US-A- 5 818 113
- PATENT ABSTRACTS OF JAPAN vol. 016, no. 542 (E-1290), 12. November 1992 (1992-11-12) & JP 04 207072 A (TOSHIBA CORP), 29. Juli 1992 (1992-07-29)
- PATENT ABSTRACTS OF JAPAN vol. 017, no. 264 (E-1370), 24. Mai 1993 (1993-05-24) & JP 05 006989 A (MATSUSHITA ELECTRON CORP), 14. Januar 1993 (1993-01-14)
- BURGSCHAT R: "Die Neue Dimension in der Weg- und Winkelmesstechnik" F & M FEINWERKTECHNIK MIKROTECHNIK MIKROELEKTRONIK, Bd. 104, Nr. 10, 1996, Seiten 752-756, XP002138966 München in der Anmeldung erwähnt

## Beschreibung

Die Erfindung betrifft eine optoelektronische Baueinheit, insbesondere eine Abtasteinheit einer Positionsmeßeinrichtung zur Längen- und Winkelmessung gemäß dem Oberbegriff des Anspruchs 1.

In der Zeitschrift F & M, Heft 10, 1996, Seiten 752 bis 756 ist eine derartige Baueinheit beschrieben. Eine Leuchtdiode ist auf einem Fotodiodenarray-Chip angeordnet, der in Flip-Chip-Technik bzw. Chip-on-glass-Technik über Goldbumps mit Leiterbahnen auf einer transparenten Glasplatte verbunden ist. Die Glasplatte ist auch Träger des Abtastgitters. Der Raum zwischen dem Fotodiodenarray-Chip und der Glasplatte ist mit einem transparenten Underfiller ausgefüllt, der zur mechanischen Stabilisierung des Aufbaus beiträgt.

Bei der Positionsmessung mit dieser Baueinheit durchstrahlt das Licht der Leuchtdiode das Abtastgitter, fällt auf einen Maßstab und wird vom Maßstabgitter reflektiert. Das reflektierte Licht gelangt noch einmal,durch das Abtastgitter und fällt auf das Fotodiodenarray, wo gegeneinander phasenverschobene sinusförmige Abtastsignale erzeugt werden. Nachteilig bei dieser Konstruktion ist jedoch, daß der Underfiller ein sehr guter Lichtleiter ist, der einen großen Teil des von der Leuchtdiode ausgestrahlten Lichtes direkt zu den Fotodioden des Fotodiodenarrays leitet. Durch Kantenstrahlung der Leuchtdiode und Streulicht, erzeugt durch Streuung im Underfiller, tritt eine hohe direkte Lichteinstrahlung von der Leuchtdiode auf die Fotodioden auf. Diese direkte Strahlung erhöht den Gleichpegel der Abtastsignale erheblich und führt zu einem ungünstigen Verhältnis von Nutzsignal zu Störsignal.

Diese Baueinheit ist auch in der nicht vorveröffentlichten WO 99/49514 A beschrieben. Zwischen einer Lichtquelle und Lichtempfängern ist ein Lichtsperrelement angeordnet. Dieses Uchtsperrelement kann gemäß Figur 7 auch ein Hineinfließen des Underfillers in den Bereich der Lichtquelle verhindern.

Aus der DE 197 20 300 A1 ist eine optische Baueinheit bekannt, bei der eine Leuchtdiode in ein Fotodiodenarray implantiert ist.

Die US 4,935,665 zeigt eine Anordnung von mehreren Leuchtdioden in Vertiefungen eines Trägers. Zur Lichtführung ist eine Platte mit reflektierenden Kanten zwischen dem Träger und einer Linsenplatte angeordnet.

In der US 5,818,113 ist eine Halbleiteranordnung in flip-chip Technik beschrieben, bei der durch Fließkanten, beispielsweise gebildet durch Randbereiche von Ausnehmungen bzw. Erhöhungen ein Einfließen von Underfiller in einen aktiven Halbleiterbereich vermieden wird. Gemäß der JP 04207072 A, US 5,786,589, JP 05006989 und der US 5,689,106 ist dieser aktive underfillerfrei gehaltene Halbteiterbereich eine lichtempfindliche Fläche.

Der Erfindung liegt die Aufgabe zugrunde, eine optoelektronische Baueinheit, insbesondere eine Abtasteinheit einer Positionsmeßeinrichtung anzugeben, die kompakt aufgebaut ist und bei der das Verhältnis von Nutzlicht zu Störlicht und somit das Verhältnis von Nutzsignal zu Störsignal verbessert wird.

Diese Aufgabe wird durch die Merkmale des Anspruchs 1 gelöst.

Die mit der Erfindung erzielten Vorteile bestehen insbesondere darin, daß durch einfache Weise der Raum um die Lichtquelle frei von Underfiller gehalten werden kann und mit dem Underfiller eine Grenzfläche geschaffen wird, die das von der Lichtquelle abgestrahlte Licht nicht direkt zu den Lichtempfängern gelangen läßt, sondern die das Licht absorbiert oder reflektiert. Das Verhältnis der Lichtanteile von Nutzlicht und Störlicht, welche die Lichtempfänger erreichen, wird verbessert. Der Gleichpegel der Abtastsignale wird verringert und das Verhältnis von Nutzsignal zu Störsignal wird somit verbessert.

Vorteilhafte Ausbildungen der Erfindung sind in den abhängigen Ansprüchen angegeben.

Ausführungsbeispiele der Erfindung werden anhand der Zeichnungen näher erläutert.
Es zeigt
- Figur 1: eine erste Abtasteinheit mit einem Maßstab im Längsschnitt,
- Figur 2: eine zweite Abtasteinheit im Längsschnitt,
- Figur 3: eine dritte Abtasteinheit im Längsschnitt,
- Figur 4: eine vierte Abtasteinheit,
- Figur 5: eine fünfte Abtasteinheit,
- Figur 6: eine sechste Abtasteinheit.

Bei den nachfolgend beschriebenen verschiedenen Ausführungsbeispielen sind übereinstimmende Teile mit gleichen Bezugsziffem bezeichnet.

Die dargestellten Beispiele zeigen eine optoelektronische Baueinheit In Form einer Abtasteinheit einer Positionsmeßeinrichtung. Diese Anwendung ist besonders vorteilhaft. Die Erfindung ist aber nicht auf diese Anwendung beschränkt, eine erfindungsgemäß ausgebildete optoelektronische Baueinheit kann auch beispielsweise zur Erfassung der Lichtadsorption von Schichten, der Reflexion an Oberflächen, der Lichtadsorption in Gasen, der Brechungsänderung von Schichten, der Totalreflexion sowie der Remission eingesetzt werden. Als Anwendungsgebiete kommen unter anderem die Gassensorik, Flüssigkeitssensorik, die Messung biologischer und humanmedizinischer Parameter, die Drucksensorik sowie die Neigungssensorik in Frage.

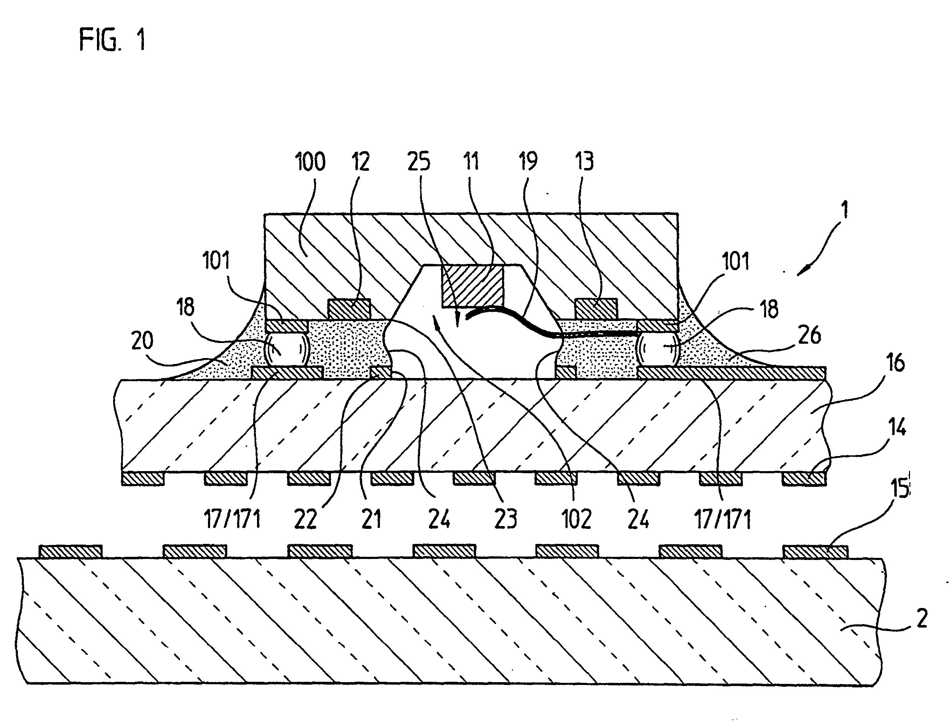

In Figur 1 ist ein erstes Ausführungsbeispiel der Erfindung dargestellt. Die Positionsmeßeinrichtung besteht aus einer optoelektronischen Baueinheit in Form einer Abtasteinheit 1 sowie einem Maßstab 2. Die Abtasteinheit 1 weist eine Lichtquelle in Form einer LED 11, mehrere Lichtempfänger 12, 13 und ein Abtastgitter 14 auf. Das Licht der LED 11 durchstrahlt das Abtastgitter 14, fällt auf den Maßstab 2 und wird von der Teilung 15 des Maßstabs 2 reflektiert. Das reflektierte Licht gelangt noch einmal durch das Abtastgitter 14 und fällt auf die Lichtempfänger 12, 13. Der Lichtanteil der LED 11, der diesen Weg durchläuft wird als Nutzlicht bezeichnet, da er zur positionsabhängigen Modulation des Lichts beiträgt. Die Relativanordnung der Lichtempfänger 12, 13, des Abtastgitters 14 und des Maßstabs 2 ist in bekannter Weise so gewählt, daß die einzelnen Lichtempfänger 12, 13 gegeneinander phasenverschobene elektrische sinusförmige Abtastsignale erzeugen. Besonders vorteilhaft ist eine symmetrische Anordnung einer Vielzahl von Lichtempfängern 12, 13 in Form eines Fotodiodenarrays, wobei die LED 11 in der Mitte des Fotodiodenarrays angeordnet ist. Diese Anordnung ist in der Zeitschrift F & M, Heft 10, 1996 auf den Seiten 752 bis 756 ausführlich beschrieben und dargestellt, weshalb sich weitere Erläuterungen hierzu erübrigen.

Das Abtastgitter 14 ist auf einer Glasscheibe 16 als abwechselnd lichtdurchlässiges und lichtundurchlässiges Strichmuster lithographisch aufgebracht. Die Glasscheibe 16 dient auch als Träger der LED 11 und der Lichtempfänger 12, 13. Hierzu ist auf der dem Abtastgitter 14 gegenüberliegenden Seite der Glasscheibe 16 ein Leiterbahn-Layout mit lithographischen Verfahren aufgebracht. Dieses Layout weist Leiterbahnen 17 mit Kontaktstellen 171 zur face down Kontaktierung auf.

Die Lichtempfänger 12, 13 sind vorteilhafterweise als eine gemeinsame Einheit in Form eines Optochips 100 aufgebaut. Der Optochip 100 ist durch die aufgesetzte LED 11 (Halbleiterchip) ergänzt. Die LED 11 ist am Optochip 100 elektrisch kontaktiert. Zur Kontaktierung des Optochips 100 weist dieser Kontaktstellen 101 auf, die in Richtung der Kontaktstellen 171 der Glasscheibe 16 weisen und mit diesen über Pumps 18 in Flip-Chip-Technik verbunden sind. Die LED 11 kann direkt auf einer ebenen Oberfläche des Optochips 100 aufgesetzt sein. Vorteilhafterweise ist die LED 11 aber im Optochip 100 implantiert. Das heißt, daß im Optochip 100 eine Vertiefung 102 zur Aufnahme der LED 11 eingebracht ist, wie in der DE 197 20 300 A1 beschrieben ist. Die Rückseite der LED 11 wird durch das Aufsetzen mittels Lötung oder mittels eines Leitklebers mit dem Optochip 100 kontaktiert. Die Vorderseite der LED 11 wird durch Drahtbonden mit dem Optochip 100 kontaktiert. Der Bonddraht ist mit dem Bezugszeichen 19 versehen.

Nachdem der die LED 11 und die Lichtempfänger 12 und 13 tragende Optochip 100 mit den Leiterbahnen 17 der Glasscheibe 16 elektrisch kontaktiert ist, wird der Raum zwischen dem Optochip 100 und der Glasscheibe 16 mit einem Underfiller 20 ausgefüllt. Der Underfiller 20 dient insbesondere zur mechanischen Stabilisierung des Aufbaus, er besteht deshalb aus einem fest aushärtenden Kunststoffmaterial hoher Festigkeit und guter Haftfähigkeit an dem Optochip 100 und an der Glasscheibe 16.

Um den Raum 25 im Bereich der Hauptabstrahlrichtung der LED 11 vom Underfiller 20 frei zu halten, ist beim ersten Ausführungsbeispiel auf der der LED 11 gegenüberliegenden Oberfläche der Glasscheibe 16 eine insbesondere umlaufende Kante 21 ausgebildet. Diese Kante 21 verhindert das Weiterfließen des Underfillers 20 vom Bereich der Lichtempfänger 12, 13 in den Bereich der LED 11. Die Kante 21 wird deshalb nachfolgend als Fließkante 21 bezeichnet. Diese Fließkante 21 kann mit dem gleichen Lithographieprozess wie die Leiterbahnen 17 aufgebracht werden. Die Fließkante 21 wird dabei von einer metallischen Schicht-Struktur 22 gebildet, welche aus dem gleichen Material besteht, wie die Leiterbahnen 17.

Am Optochip 100 ist gegenüber der Fließkante 21 eine weitere insbesondere umlaufende Fließkante 23 ausgebildet. Diese Fließkante 23 kann von einer separaten Struktur gebildet sein, oder im Optochip 100 durch eine Vertiefung oder eine Erhöhung ausgebildet sein. Im dargestellten Beispiel wird die Fließkante 23 durch die Vertiefung 102 gebildet. Der Underfiller 20 wird von außen in den Zwischenraum von Optochip 100 und Glasscheibe 16 eingebracht, dabei fließt er aufgrund der Kapillarwirkung bis zu den Fließkanten 21, 23, bei denen das Weiterfließen verhindert wird. Der Raum 25 zwischen LED 11 und der Glasscheibe 16 kann somit auf einfache Weise underfillerfrei gehalten werden. Durch die Fließkanten 21, 23 bildet sich eine Grenzfläche 24 zwischen dem Underfiller 20 und dem freien Raum 25 aus. Diese Grenzfläche 24 ist eine Oberfläche des Underfillers 20, welche die Transmission des von der LED 11 ausgehenden Lichtes erheblich reduziert, indem das auftreffende Licht reflektiert und/oder absorbiert wird.

Beide Fließkanten 21 und 23 können als Schicht-Struktur, als Vertiefung, als Erhebung oder als Oberflächenrauhigkeit ausgebildet sein.

Der Underfiller 20 ist für den Lichtwellenlängenbereich transparent, der von der LED 11 gesendet bzw. von der Lichtempfängern 12, 13 detektiert wird.

Er sollte einen thermischen Ausdehnungskoeffizienten haben, der an die Komponenten des Flip-Chip-Aufbaus angepaßt ist und somit keine mechanischen Spannungen hervorruft. Zur Anpassung und Verringerung des Ausdehnungskoeffizienten ist der Underfiller 20 üblicherweise mit Quarzmehl 26 oder Quarzkugeln gefüllt bzw. versetzt. Die Oberfläche des Underfillers 20 ist dadurch an der Grenzfläche 24 relativ rauh, wodurch die Transmission weiter verringert wird.

Das zu den Lichtempfängern 12, 13 gelangende Störlicht und somit auch der Gleichpegel der Abtastsignale wird erheblich reduziert. Weiterhin befindet sich die LED 11 in einem Freiraum 25 mit Luft, die eine beliebige Ausdehnung der LED 11 zuläßt. Eine Häufung des Underfillers 20 im Raum der LED 11 entfällt, dadurch werden die bei Temperaturänderung auftretenden mechanischen Spannungen im Bereich der LED 11 erheblich reduziert. Da die Grenzfläche 24 keine mechanische Barriere für den Bonddraht 19 darstellt, ist eine einfache Fertigung möglich. Die Grenzfläche 24 bildet eine Art Lichtdichtung, wobei sich die Bonddraht-Öffnung entsprechend dem Verlauf des Bonddrahts 19 selbständig ausbildet.

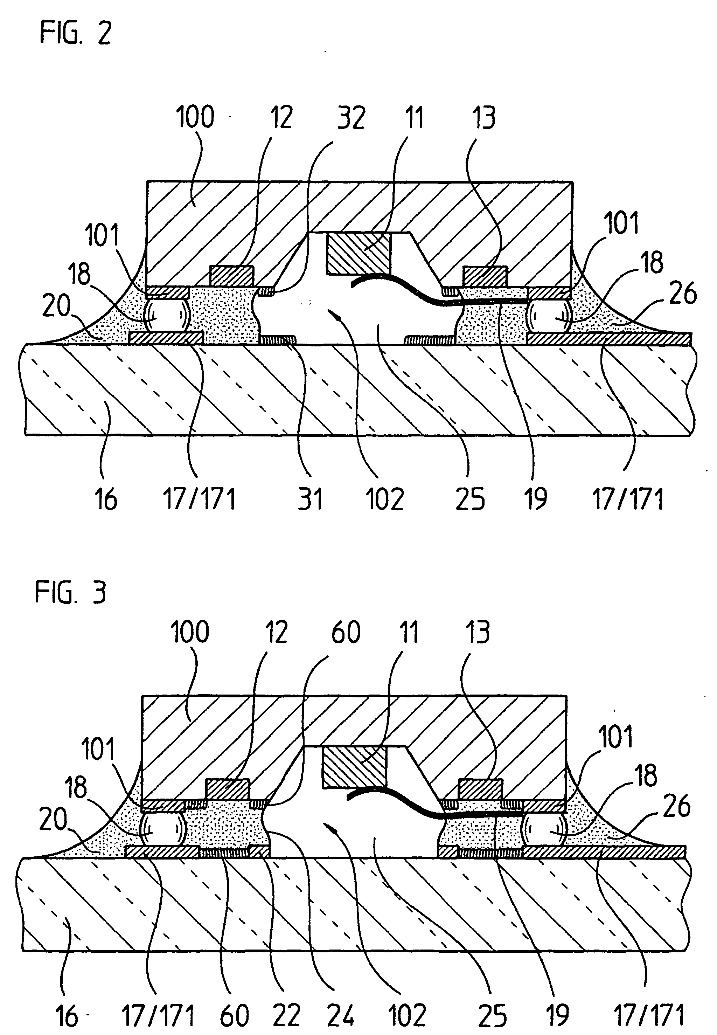

Figur 2 zeigt ein weiteres Beispiel einer Abtasteinheit. Der Grundaufbau entspricht dem der Figur 1, weshalb nur die davon abweichenden Merkmale nachfolgend erläutert werden.

Zur Ausbildung einer Grenzfläche 24 ist anstelle von Fließkanten 21, 23 eine andere Maßnahme vorgesehen. An der Stelle, an der das Weiterfließen des Underfillers 10 verhindert werden soll, ist die Oberfläche 31 der Glasscheibe 16 und die Oberfläche 32 des Optochips 100 derart behandelt, daß die Benetzungsfähigkeit dieser Oberflächenbereiche 31, 32 stark verringert ist. Diese Maßnahme wird auch als Hydrophobierung bezeichnet. Der physikalische Effekt ist dabei die Erhöhung der Grenzflächenspannung der Oberflächenbereiche 31 und 32 um das Benetzungsvermögen zu verringern. Die Oberflächenbereiche 31, 32 können Beschichtungen mit Teflon oder diamant like carbon sein. Diese Maßnahme kann alternativ oder zusätzlich zu der Maßnahme gemäß Figur 1 eingesetzt werden. Wenn sie zusätzlich eingesetzt wird, kann der Oberflächenbereich 31 der Glasscheibe 16 auch die Struktur 22 sein. Es ist auch möglich, die zu Figur 1 und 2 beschriebenen Maßnahmen miteinander zu kombinieren. Die Struktur 22 besteht dabei aus einer Schicht, die eine mechanische Barriere und eine Art chemische Barriere für den Underfiller 20 bildet. Die Struktur 22 ist beispielsweise aus Teflon oder einer Teflon-Chrom-Verbindung, also einem Material, welches eine geringe Benetzungsfähigkeit aufweist.

Zusätzlich kann bei allen Ausführungsbeispielen das Benetzungsverhalten der Glasscheibe 16 und des Optochips 100 in dem Bereich, in dem der Undefiller 20 gut einfließen soll, gezielt verbessert werden, indem dieser Oberflächenbereich mit einem Material 60 beschichtet wird, welches eine hohe Benetzungsfähigkeit aufweist. Die Benetzungsfähigkeit wird beispielsweise durch die Beschichtung mit Hexamethyldisilizan erheblich verbessert. Ein Ausführungsbeispiel dazu ist in Figur 3 dargestellt.

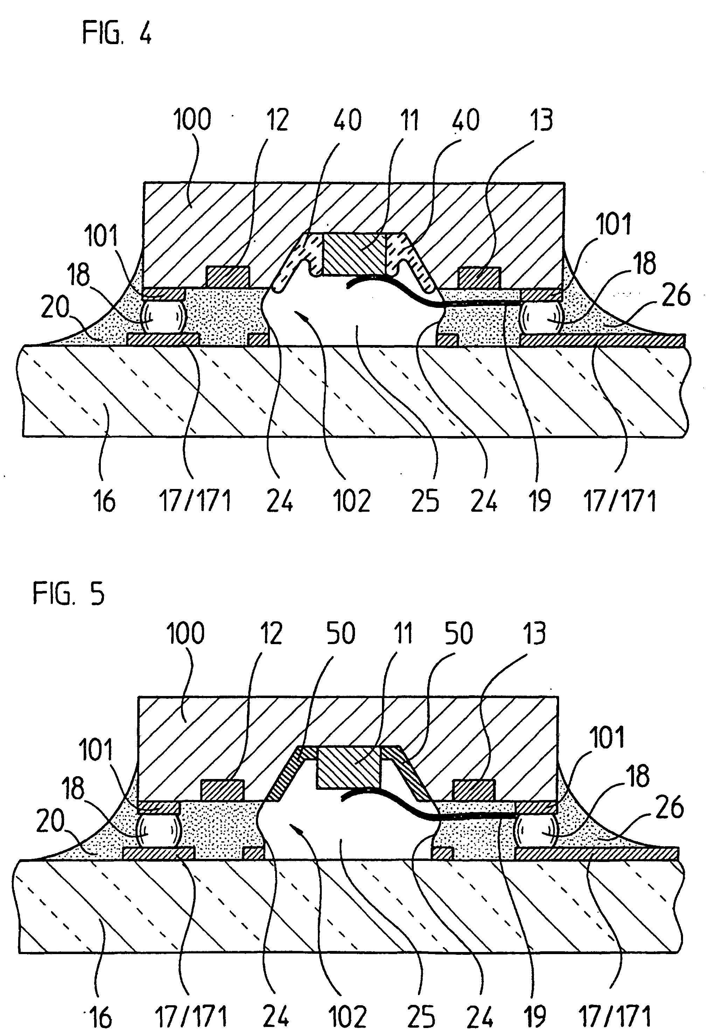

Zur weiteren Reduzierung von Streulicht können die seitlichen Kanten der LED 11 und/oder die Oberflächenbereiche des Optochips 100 im Raum 25 um die LED 11 absorbierend ausgebildet sein. Diese Oberfläche des Optochips 100 und/oder die seitlichen Kanten der LED 11 weisen dazu eine lichtabsorbierende Oberfläche beispielsweise in Form einer lichtabsorbierenden Schicht 40 auf. Dieses Ausführungsbeispiel ist in Figur 4 schematisch dargestellt.

Als Alternative können die seitlichen Kanten der LED 11 und/oder die Oberfläche des Optochips 100 im Raum 25 reflektierend beschichtet sein. Als reflektierendes Material kann eine Metallschicht 50 verwendet werden. Dieses Beispiel ist in Figur 5 schematisch dargestellt.

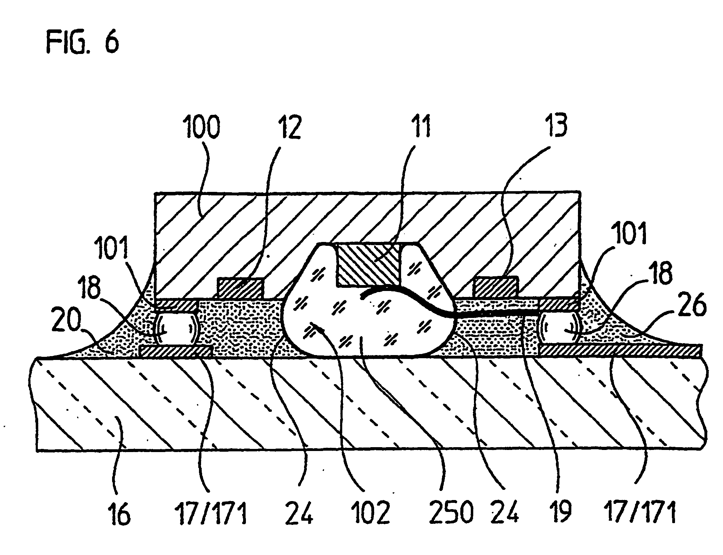

Ein sechstes Ausführungsbeispiel wird anhand von Figur 6 erläutert. Dabei wird ein underfillerfreier Raum geschaffen, indem zwischen der LED 11 und der Glasscheibe 16 anstelle von Luft ein hochtransparentes Material 250 vorgesehen ist. Dieses transparente Material 250 ist vorzugsweise ein elastisches Material, beispielsweise Silikon, welches den Optochip 100 mit der Glasscheibe 16 nur elastisch verbindet. Die am Optochip 100 montierte LED 11 wird mit diesem Material 250 umgeben. Die Dicke des Materials 250 wird so gewählt, daß es beim Aufsetzen und Löten des Optochips 100 auf die Glasscheibe 16 auf dieser aufliegt und einen Raum zwischen LED 11 und Glasscheibe 16 gegenüber dem danach einzubringenden Underfiller 20 ausfüllt und abdichtet.

Das elastische transparente Material 250 kann auch auf der Glasscheibe 16 aufgebracht werden, wobei sich der abzudichtende Raum wiederum durch das Aufsetzen des Optochips 100 auf die Glasscheibe 16 ergibt. Nach dem Aufsetzen und Löten des Optochips 100 wird der Underfiller 20 eingebracht, der bis zu dem Material 250 fließt und dort die Grenzfläche 24 bildet.

Das Vorsehen eines elastischen transparenten Materials 250 im Bereich der LED 11 hat widerum den Vorteil, daß in diesem Bereich thermische Ausdehnungen keine Spannungen erzeugen können, da sich das elastische Material 250 anpaßt. Weiterhin ist keine Kondensation in diesem Bereich möglich. Die erforderliche Stabilität wird durch den nicht elastischen Underfiller 20 erreicht, der den Optochip 100 starr mit der Glasscheibe 16 verbindet. Der Underfiller 20 härtet fest aus und haftet gut an den Oberflächen des Optochips 100 und der Glasplatte 16.

Bei allen Ausführungsbeispielen kann der Optochip 100 auch Schaltkreise zur Verarbeitung der Abtastsignale der Lichtempfangselemente enthalten. Die Schaltkreise zur Verarbeitung der Abtastsignale können auch als separate Bauelemente in Flip-Chip-Technik auf der Glasscheibe 16 kontaktiert und befestigt sein.

Anstelle einer Glasscheibe 16 kann als Träger auch ein anderes transparentes Material, beispielsweise Mylar verwendet werden.

Weiterhin kann das Abtastgitter 14 auch auf der anderen Seite der Glasscheibe 16 angebracht sein. Dies hat den Vorteil, daß das Abtastgitter 14, die Leiterbahnen 17 und die Struktur 22 für die Fließkante 21 auf der gleichen Oberfläche und somit im gemeinsamen Verfahrensprozeß hergestellt werden können. Die Struktur 22 zur Bildung der Fließkante 21 kann dabei Bestandteil des Abtastgitters 14 sein.

Die Teilung 15 kann eine inkrementale und/oder eine ein- bzw. mehrspurige absolute Codeteilung sein.

## Patentansprüche

1. Optoelektronische Baueinheit (1) mit
- einem Substrat (100), welches nebeneinander angeordnet zumindest eine Lichtquelle (11) und einen Lichtempfänger (12, 13) aufweist und welches Kontaktstellen (101) zur elektrischen Kontaktierung besitzt,
- einem Träger (16) des Substrats (100) mit elektrischen Leiterbahnen (17) und Kontaktstellen (171), wobei diese Kontaktstellen (171) den Kontaktstellen (101) des Substrats (100) gegenüberliegen und mit diesen elektrisch kontaktiert sind,
- einem Underfiller (20) in einem Raum zwischen dem Substrat (100) und dem Träger (16), **dadurch gekennzeichnet, daß**
- der Underfiller (20) transparent ist und im Raum zwischen dem Lichtempfänger (12, 13) und dem Träger (16) vorhanden ist, wobei der Raum (25) zwischen der Lichtquelle (11) und dem Träger (16) underfillerfrei ist, und daß
- der transparente Underfiller (20) zwischen dem Substrat (100) und dem Träger (16) eine Grenzfläche (24) zu dem transparenten undefillerfreien Raum (25) bildet, wobei die Grenzfläche (24) den transparenten underfillerfreien Raum (25) der Lichtquelle (11) begrenzt, indem der transparente Underfiller (20) direkt an diesem angrenzt.

2. Optoelektronische Baueinheit nach Anspruch 1, **dadurch gekennzeichnet, daß** am Substrat (100) zwischen der Lichtquelle (11) und dem Lichtempfänger (12, 13) eine Kante (23) ausgebildet ist, und gegenüberliegend am Träger (16) eine weitere Kante (21) ausgebildet ist, und daß der Underfiller (20) den Abstand zwischen den beiden Kanten (23, 21) überbrückt und dort die Grenzfläche (24) ausgebildet ist.

3. Optoelektronische Baueinheit nach Anspruch 1 oder 2, **dadurch gekennzeichnet, daß** an der Grenzfläche (24) die Benetzungsfähigkeit des Substrats (100) und des Trägers (16) verringert ist.

4. Optoelektronische Baueinheit nach einem der vorhergehenden Ansprüche, **dadurch gekennzeichnet, daß** der underfillerfreie Raum von einem hochtransparenten elastischen Material (250) gebildet ist, an das der Underfiller (20) angrenzt.

5. Optoelektronische Baueinheit nach einem der vorhergehenden Ansprüche, **dadurch gekennzeichnet, daß** das Substrat ein Halbleitersubstrat (100) ist, in dem mehrere Lichtempfänger (12, 13) ausgebildet sind, und an dem die Lichtquelle (11) befestigt und elektrisch kontaktiert ist.

6. Optoelektronische Baueinheit nach Anspruch 5, **dadurch gekennzeichnet, daß** das Halbleitersubstrat (100) eine Ausnehmung (102) aufweist, in weiche die Lichtquelle (11) eingesetzt ist.

7. Optoelektronische Baueinheit nach einem der vorhergehenden Ansprüche, **dadurch gekennzeichnet, daß** ein Oberflächenbereich der Lichtquelle (11) und/oder des Substrats (100) im underfillerfreien Raum (25, 250) absorbierend ausgebildet, insbesondere beschichtet ist.

8. Optoelektronische Baueinheit nach einem der vorhergehenden Ansprüche, **dadurch gekennzeichnet, daß** ein Oberflächenbereich des Substrats (100) im underfilterfreien Raum (25, 250) reflektierend beschichtet ist.

9. Optoelektronische Baueinheit nach einem der vorhergehenden Ansprüche, **dadurch gekennzeichnet, daß** Oberflächenbereiche des Substrats (100) und/oder des Trägers (16), zwischen denen der Underfiller (20) vorgesehen ist, mit einem Material (60) beschichtet sind, welches eine hohe Benetzungsfähigkeit aufweist.

10. Optoelektronische Baueinheit nach einem der vorhergehenden Ansprüche, **dadurch gekennzeichnet, daß** der Träger (16) aus einem transparenten Material besteht, und daß auf dem Träger (16) ein Abtastgitter (14) ausgebildet ist

11. Optoelektronische Baueinheit nach einem der vorhergehenden Ansprüche, **dadurch gekennzeichnet, daß** diese eine Abtasteinheit (1) einer Positionsmeßeinrichtung zur Abtastung eines Maßstabes (2) ist.

## Claims

1. Optoelectronic component (1) having
• a substrate (100), which has at least one light source (11) and a light receiver (12, 13) arranged next to one another, and which has contact points (101) for electrical connections,
• a support (16) of the substrate (100) with electrical strip conductors (17) and contact points (171), wherein these contact points (171) are located opposite the contact points (101) of the substrate (100) and are connected electrically with these,
• an underfiller (20) in a space between the substrate (100) and the support (16), **characterised in that**
• the underfiller (20) is transparent and is situated in the space between the light receiver (12, 13) and the support (16), wherein the space (25) between the light source (11) and the support (16) is underfiller-free, and that
• between the substrate (100) and the support (16) the transparent underfiller (20) forms a border area (24) to the transparent underfiller-free space (25), wherein the border area (24) restricts the transparent underfiller-free space (25) of the light source (11) by virtue of the transparent underfiller (20) directly bordering this space.

2. Optoelectronic component according to Claim 1, **characterised in that** an edge (23) is formed on the substrate (100) between the light source (11) and the light receiver (12, 13), and on the opposite side a further edge (21) is formed on the support (16), and that the underfiller (20) bridges the distance between the two edges (23, 21) and the border area (24) is formed there.

3. Optoelectronic component according to Claim 1 or 2, **characterised in that** the wetting capability of the substrate (100) and the support (16) is reduced at the border area (24).

4. Optoelectronic component according to one of the preceding claims, **characterised in that** the underfiller-free space is formed by a highly transparent elastic material (250), which is bordered by the underfiller (20).

5. Optoelectronic component according to one of the preceding claims, **characterised in that** the substrate is a semiconductor substrate (100), in which a plurality of light receivers (12, 13) are configured, and on which the light source (11) is fastened and electrically connected.

6. Optoelectronic component according to Claim 5, **characterised in that** the semiconductor substrate (100) has a recess (102), into which the light source (11) is inserted.

7. Optoelectronic component according to one of the preceding claims, **characterised in that** a surface area of the light source (11) and/or of the substrate (100) in the underfiller-free space (25, 250) is configured to be absorbent, in particular is coated.

8. Optoelectronic component according to one of the preceding claims, **characterised in that** a surface area of the substrate (100) in the underfiller-free space (25, 250) is reflectively coated.

9. Optoelectronic component according to one of the preceding claims, **characterised in that** surface areas of the substrate (100) and/or of the support (16), between which the underfiller (20) is provided, are coated with a material (60), which has a high wetting capability.

10. Optoelectronic component according to one of the preceding claims, **characterised in that** the support (16) is made of a transparent material, and that a scanning grating (14) is formed on the support (16).

11. Optoelectronic component according to one of the preceding claims, **characterised in that** this is a scanning unit (1) of a position measuring device for scanning a scale (2).

## Revendications

1. Ensemble optoélectronique (1) modulaire comprenant
un substrat (100) qui présente, disposés l'un à côté de l'autre, au moins une source lumineuse (11) et un récepteur de lumière (12, 13) et porte des zones de contact (101) pour la connexion électrique,
un support (16) du substrat (100) avec des pistes conductrices (17) électriques et des zones de contact (171), lesdites zones de contact (171) étant disposées en regard des zones de contact (101) du substrat (100) et étant connectées électriquement à celles-ci,
un matériau de remplissage (20) disposé dans un espace entre le substrat (100) et le support (16), **caractérisé par le fait que**
le matériau de remplissage (20) est transparent et est présent dans l'espace entre le récepteur de lumière (12, 13) et le support (16), l'espace (25) entre la source lumineuse (11) et le support (16) étant exempt de matériau de remplissage, et **par le fait que**
le matériau de remplissage (20) transparent entre le substrat (100) et le support (16) forme une interface (24) avec l'espace (25) transparent exempt de matériau de remplissage, l'interface (24) délimitant l'espace (25) transparent, exempt de matériau de remplissage, de la source lumineuse (11) étant donné que ledit matériau de remplissage (20) transparent est directement voisin de celui-ci.

2. Ensemble optoélectronique modulaire selon la revendication 1, **caractérisé par le fait qu'**une arête (23) est formée sur le substrat (100) entre la source lumineuse (11) et le récepteur de lumière (12, 13) et une arête (21) supplémentaire est formée en vis-à-vis sur le support (16), et **par le fait que** le matériau de remplissage (20) ponte l'espace entre les deux arêtes (23, 21) et que l'interface (24) est formée à ce niveau.

3. Ensemble optoélectronique modulaire selon la revendication 1 ou 2, **caractérisé par le fait qu'**au niveau de l'interface (24) l'aptitude au mouillage du substrat (100) et du support (16) est réduite.

4. Ensemble optoélectronique modulaire selon une des revendications précédentes, **caractérisé par le fait que** l'espace exempt de matériau de remplissage est formé d'un matériau (250) élastique à transparence élevée avec lequel le matériau de remplissage (20) est contigu.

5. Ensemble optoélectronique modulaire selon une des revendications précédentes, **caractérisé par le fait que** le substrat est un substrat semi-conducteur (100) dans lequel plusieurs récepteurs de lumière (12, 13) sont formés et auquel la source lumineuse (11) est fixée et connectée électriquement.

6. Ensemble optoélectronique modulaire selon la revendication 5, **caractérisé par le fait que** le substrat semi-conducteur (100) présente un évidement (102) dans lequel la source lumineuse (11) est insérée.

7. Ensemble optoélectronique modulaire selon une des revendications précédentes, **caractérisé par le fait qu'**une portion de surface de la source lumineuse (11) et/ou du substrat (100), dans l'espace (25, 250) exempt de matériau de remplissage, est rendue absorbante, en particulier est pourvue d'un revêtement.

8. Ensemble optoélectronique modulaire selon une des revendications précédentes, **caractérisé par le fait qu'**une portion de surface du substrat (100) dans l'espace (25, 250) exempt de matériau de remplissage est pourvue d'un revêtement réfléchissant.

9. Ensemble optoélectronique modulaire selon une des revendications précédentes, **caractérisé par le fait que** des portions de surface du substrat (100) et/ou du support (16) entre lesquelles le matériau de remplissage (20) est prévu, sont revêtues d'un matériau (60) qui présente une aptitude au mouillage élevée.

10. Ensemble optoélectronique modulaire selon une des revendications précédentes, **caractérisé par le fait que** le support (16) est en un matériau transparent et **par le fait qu'**un réseau de palpage (14) est formé sur le support (16).

11. Ensemble optoélectronique modulaire selon une des revendications précédentes, **caractérisé par le fait que** ledit ensemble est une unité de palpage (1) d'un dispositif de mesure de position assurant le palpage d'une graduation (2).
